**Europäisches Patentamt**

**European Patent Office**

**Office européen des brevets**

(19)

(11) Numéro de publication: **0 150 880**
**B1**

(12) # FASCICULE DE BREVET EUROPÉEN

(45) Date de publication du fascicule du brevet:
**21.09.88**

(21) Numéro de dépôt: **85200058.7**

(22) Date de dépôt: **21.01.85**

(51) Int. Cl.⁴: **H 03 D 3/24,** H 03 G 3/20, H 04 N 5/44

(54) **Démodulateur à boucle à verrouillage de phase.**

(30) Priorité: **25.01.84 FR 8401127**

(43) Date de publication de la demande:
**07.08.85 Bulletin 85/32**

(45) Mention de la délivrance du brevet:
**21.09.88 Bulletin 88/38**

(84) Etats contractants désignés:
**DE FR GB IT**

(56) Documents cité:
**DE-A-2 250 724**
**GB-A-2 053 599**
**US-A-3 209 271**
**US-A-4 339 828**

**PATENTS ABSTRACTS OF JAPAN, vol. 7, no. 204 (E-197) 1349 , 9 septembre 1983**

(73) Titulaire: **PORTENSEIGNE, 50 rue Roger Salengro Péripole 114, F-94126 Fontenay- sous- Boix Cédex (FR)**
(84) Etats contractants désignés: **FR**

(73) Titulaire: **N.V. Philips' Gloeilampenfabrieken, Groenewoudseweg 1, NL- 5621 BA Eindhoven (NL)**
(84) Etats contractants désignés: **DE GB IT**

(72) Inventeur: **Horvat, Philippe, Société Civile S.P.I.D. 209 rue de l'Université, F-75007 Paris (FR)**

(74) Mandataire: **Landousy, Christian, Société Civile S.P.I.D. 209, Rue de l'Université, F-75007 Paris (FR)**

EP 0 150 880 B1

## Description

La présente invention concerne un démodulateur à boucle à verrouillage de phase. Un domaine d'application particulièrement intéressant de cette invention est celui de la télédiffusion par satellite.

En effet, les liaisons spatiales font appel de préférence à des modulations d'angle (phase ou fréquence) pour deux raisons principales la limitation en puissance des émetteurs placés à bord des satellites, la nécessité d'une immunité au bruit de fond aussi élevée que possible. A la réception de signaux provenant ainsi d'un satellite, pour tirer le meilleur parti de ceux-ci, trois paramètres principaux sont à optimiser: le gain de l'antenne de réception, le facteur de bruit de l'amplificateur hyperfréquence d'entrée, le seuil de démodulation. C'est le réglage de ce troisième paramètre, le seuil du démodulateur, qui fait l'objet de la présente invention.

Quel que soit le démodulateur utilisé, la courbe $P_{SV}/P_{BV} = f(P_{HF}/P_{BC})$, où $P_{SV}$, $P_{BV}$, $P_{HF}$ et $P_{BC}$ représentent respectivement la puissance du signal vidéo démodulé, la puissance du bruit vidéo, la puissance de la porteuse HF et la puissance du bruit HF dans le canal, présente un coude au-dessus duquel les rapports $P_{HF}/P_{BC}$ et $P_{SV}/P_{BV}$ évoluent de façon sensiblement proportionnelle, mais au-dessou duquel $P_{SV}/P_{BV}$ se dégrade très rapidement lorsque $P_{HF}/P_{BC}$ diminue. La valeur de $P_{HF}/P_{BC}$ correspondant à ce coude, ou seuil de démodulation, dépend du type de démodulateur utilisé.

Pour l'application particulière envisagée (réception de signaux de télévision transmis par satellites), les démodulateurs de fréquence utilisables sont de deux types principaux, à savoir les démodulateurs à déphasage associés à des limiteurs et les démodulateurs à boucle à verrouillage de phase associés à un amplificateur à commande automatique de gain. L'invention décrite plus loin concerne ces démodulateurs à boucle, qui, pour une bande passante et une qualité de démodulation comparables, présentent un seuil meilleur (de deux décibels environ, dans le cas présent, en l'absence de l'invention). Une telle performance n'est cependant pas encore suffisante lorsque les conditions de bruit deviennent réellement mauvaises.

Pour améliorer la réception dans les cas où les signaux d'entrée deviennent faibles et où la distorsion de modulation est importante, la demande de brevet japonais n° 56-199 633, déposée le 10 décembre 1981 et qui décrit un démodulateur comprenant essentiellement un circuit de commande automatique de gain, une boucle à verrouillage de phase et une connexion de retour permettant une rétroaction de la boucle sur le circuit de commande automatique de gain, prévoit comme type de rétroaction la modification de la capacité d'un condensateur variable du circuit d'accord situé à l'entrée du démodulateur, afin de disposer d'un circuit de filtrage étroit permettant de réduire la bande équivalente de bruit et d'accompagner le signal incident dans son excursion de fréquence.

Le but de l'invention est aussi d'améliorer les conditions de réception dans un démodulateur tel que celui décrit dans la demande japonaise citée, mais en prévoyant un autre type de rétroaction portant cette fois sur l'amplitude du signal incident et non pas sur son filtrage.

L'invention concerne à cet effet un démodulateur de phase ou de fréquence comprenant d'une part un circuit de commande automatique de gain destiné à fournir à partir de la porteuse incidente non régulée un signal modulé de niveau moyen constant, d'autre part une boucle à verrouillage de phase destinée à fournir à partir dudit signal modulé un signal démodulé, et éventuellement un circuit de mise en forme du signal de sortie de la boucle, une connexion de rétroaction étant en outre prévue entre la sortie de la boucle ou du circuit de mise en forme et le circuit de commande automatique de gain, ledit démodulateur étant caractérisé en ce que ladite connexion est effectuée par l'intermédiaire d'un circuit de contrôle automatique de bruit destiné à délivrer un signal analogique proportionnel à la densité des décrochements temporaires de la boucle.

La structure proposée présente l'intérêt de fournir de manière simple une mesure du bruit affectant les signaux d'entrée du démodulateur, en évaluant la densité des décrochements de boucle dûs au bruit et en modifiant d'après cette évaluation le gain du circuit de commande automatique de gain.

Les particularités et avantages de l'invention apparaitront maintenant de façon plus détaillée dans la description qui suit et dans les dessins annexés, donnés à titre d'exemples non limitatifs et dans lesquels:
- la figure 1 montre un exemple de réalisation d'un démodulateur équipé du circuit de contrôle automatique de bruit selon l'invention;
- la figure 2 montre en détail un exemple de réalisation du circuit de contrôle automatique de bruit.

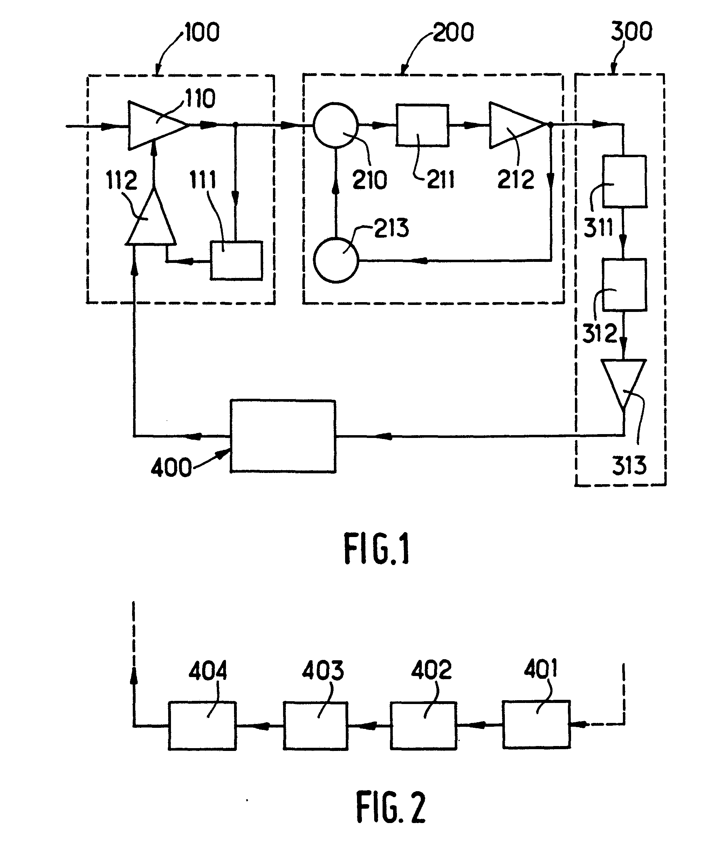

Le démodulateur représenté sur la figure 1 comprend les circuits suivants un circuit 100 de commande automatique de gain, une boucle à verrouillage de phase 200, un circuit 300 de mise en forme, un circuit 400 de contrôle automatique de bruit. Ces circuits sont successivement détaillés ci-dessous.

Le circuit 100 de commande automatique de gain comprend un amplificateur 110 à gain commandable par tension qui reçoit la porteuse présente à l'entrée du démodulateur et dont la sortie est mesurée par un détecteur 111 (par exemple une diode détectrice). La valeur d'amplitude ainsi obtenue est envoyée sur la première borne d'un amplificateur 112 dans lequel cette valeur est comparée à une tension de référence présente sur la deuxième borne de l'amplificateur et déterminée d'une manière qui sera indiquée plus loin; la tension d'erreur délivrée par cet amplificateur 112 commande le gain de l'amplificateur 110. Ce circuit 100 de commande automatique de gain permet de présenter à l'entrée du circuit 200, qui constitue la partie réellement démodulatrice, la porteuse modulée en fréquence avec un niveau moyen rendu constant.

La boucle à verrouillage de phase 200 comprend de façon classique un comparateur de phase, un filtre de boucle (éventuellement), un amplificateur et un oscillateur à commande par tension. Le comparateur de phase, qui est ici un mélangeur équilibré 210, reçoit d'une part la porteuse régulée délivrée par l'amplificateur 110 du circuit 100 et d'autre part le signal de sortie d'un oscillateur local 213 et délivre une tension sensiblement proportionnelle à l'écart de phase entre ces deux signaux incidents. Cette tension, après traversée du filtre de boucle 211, est reçue par l'amplificateur 212 qui délivre une tension amplifiée constituant à la fois le signal de sortie de la boucle et le signal de commande de la fréquence de l'oscillateur 213. Grâce à cette commande, dans la boucle ainsi verrouillée en phase, l'oscillateur 213 reproduit fidèlement les variations de fréquence du signal incident (ce signal incident est la porteuse régulée en niveau fournie par le circuit 100 de commande automatique de gain). Le circuit de mise en forme 300 comprend un filtre passe-bas 311 de désaccentuation, un filtre coupe-bande 312 de suppression de la ou des sous-porteuses son et un amplificateur 313 amenant le signal vidéo au niveau qui correspond au standard de transmission concerné.

Conformément à l'invention, la connexion de retour vers le circuit 100 de commande automatique de gain, assurée ici à partir de la sortie du circuit 300 sinon, si celui-ci n'est pas prévu, à partir de la sortie de la boucle à verrouillage de phase 200, est réalisée par l'intermédiaire du circuit 400 de contrôle automatique de bruit qui prélève le signal de sortie du démodulateur (selon le cas, le signal de sortie de l'amplificateur 313 du circuit 300 ou de l'amplificateur 212 de la boucle 200) et le réinjecte après traitement approprié décrit ci-dessous sur la deuxième borne de l'amplificateur 112 où il constitue ladite valeur de tension de référence.

Le circuit 400 de contrôle automatique de bruit comprend, de façon plus précise, un circuit 401 d'alignement sur le niveau inférieur des impulsions de synchronisation (circuit dit de clamping), un circuit 402 d'effacement de ces impulsions, un circuit de comparaison 403 et un circuit 404 de mesure de densité d'impulsions.

Le fonctionnement de ce circuit 400 est le suivant. Lorsque le bruit sur la porteuse augmente (entraînant donc une diminution de $P_{HF}/P_{BC}$), le bruit vidéo s'accroît, il y a diminution également de $P_{SV}/P_{BV}$, et la boucle 200 décroche de façon transitoire lorsqu'on approche du seuil de démodulation. Ces décrochements aléatoires provoquent sur le signal démodulé des excursions de tension positives et négatives, sous forme d'impulsions de durée et d'amplitude homogènes qui font apparaître sur l'image de télévision des points blancs et des points noirs détériorant très fortement la qualité de cette image. Une diminution du gain global de boucle permet, par abaissement du seuil de démodulation, une amélioration du rapport $P_{SV}/P_{BV}$ et une diminution notable du nombre des impulsions de décrochement.

Cette diminution du gain de boucle est assurée ici par réduction de la sensibilité du mélangeur 210, en diminuant l'amplitude de la porteuse incidente. Une telle diminution est obtenue en modifiant la tension de référence de l'amplificateur 112 en fonction de la densité des impulsions de décrochement de la boucle 200. En effet, après alignement et effacement des impulsions de synchronisation, le circuit de comparaison 403 du circuit 400 permet, à l'aide de deux comparateurs en parallèle l'un à seuil haut et l'autre à seuil bas, d'éliminer pratiquement le signal vidéo et de ne sélectionner que les impulsions positives et les impulsions négatives qui se sont superposées à lui. Le circuit 404 fournit alors, par exemple par intégration ou par différentiation et calcul de valeur moyenne, une tension proportionnelle à la densité de ces impulsions et qui est l'information utile fournie sur l'entrée de référence de l'amplificateur 112. Une solution numérique par comptage des impulsions est, bien entendu, également possible, en prévoyant alors un convertisseur numérique-analogique avant réinjection sur l'amplificateur 112.

Au lieu de détecter les passages par deux seuils situés de part et d'autre du signal vidéo, on peut n'effectuer que l'une seule de ces détections. On peut également réaliser cette mesure de densité d'impulsions non plus pendant la durée du signal vidéo mais pendant celle des impulsions de synchronisation, en prévoyant un alignement sur le niveau inférieur de ces impulsions mais pas leur effacement (puis, comme précédemment, comparaison à un seuil approprié et mesure de la densité des impulsions négatives superposées à ces impulsions de synchronisation).

## Revendications

1. Démodulateur de phase ou de fréquence comprenant d'une part un circuit (100) de commande automatique de gain destiné à fournir à partir de la porteuse incidente non régulée un signal modulé de niveau moyen constant, d'autre part une boucle à verrouillage de phase (200) destinée à fournir à partir dudit signal modulé un signal démodulé, et éventuellement un circuit (300) de mise en forme du signal de sortie de la boucle, une connexion de rétroaction étant en outre prévue entre la sortie de la boucle ou du circuit de mise en forme et le circuit de commande automatique de gain, ledit démodulateur étant caractérisé en ce que ladite connexion est effectuée par l'intermédiaire d'un circuit (400) de contrôle automatique de bruit destiné à délivrer un signal analogique proportionnel à la densité des décrochements temporaires de la boucle.

2. Démodulateur selon la revendication 1, caractérisé en ce que le circuit (400) de contrôle automatique de bruit comprend un circuit d'alignement sur le niveau inférieur des impulsions de synchronisation, un circuit de comparaison à un seuil de référence au plus égal à ce niveau, et un circuit de mesure de la densité des impulsions négatives descendant au-dessous de ce seuil.

3. Démodulateur selon la revendication 1, caractérisé en ce que le circuit (400) de contrôle automatique de bruit comprend un circuit d'alignement sur le niveau inférieur des impulsions de synchronisation, un circuit d'effacement de ces impulsions, un circuit de comparaison à deux seuils de référence déterminés, respectivement inférieur ou égal à ce niveau et supérieur à un niveau dit de blanc, et un circuit de mesure de la densité des impulsions négatives descendant audessous du seuil inférieur et des impulsions positives dépassant le seuil supérieur.

4. Démodulateur selon la revendication 1, caractérisé en ce que le circuit (400) de contrôle automatique de bruit comprend un circuit d'alignement sur un niveau supérieur dit de blanc, un circuit de comparaison à un seuil de référence au moins égal à ce niveau, et un circuit de mesure de la densité des impulsions positives dépassant le seuil de référence.

5. Démodulateur selon l'une des revendications 2 à 4, caractérisé en ce que le circuit de mesure de densité d'impulsions comprend un compteur suivi d'un convertisseur numérique-analogique.

**Patentansprüche**

1. Phasen- oder Frequenzdemodulator mit einerseits einer Schaltungsanordnung (100) zur automatischen Verstärkungsregelung zum ausgehend von der nicht geregelten eintreffenden Trägerwelle Liefern eines modulierten Signals mit konstantem mitteleren Pegel, und andererseits einer Phasenverriegelungsschleife (200) zum ausgehend von dem modulierten Signal Liefern eines demodulierten Signals und ggf. mit einer Schaltungsanordnung (300) zum Formieren des Schleifenausgangssignals, wobei ausserdem eine Rückkopplungsverbindung zwischen dem Ausgang der Schleife oder der Formierungsschaltung und der Schaltungsanordnung zur automatischen Verstärkungsregelung vorgesehen ist, wobei der Demodulator dadurch gekennzeichnet ist, dass die Verbindung mittels einer Schaltungsanordnung (400) zur automatischen Rauschregelung zum Liefern eines zu der Dichte der zeitweiligen Ausrastungen der Schleife proportionalen analogen Signals hergestellt wird.

2. Demodulator nach Anspruch 1, dadurch gekennzeichnet, dass die Schaltungsanordnung (400) zur automatischen Rauschregelung eine Schaltungsanordnung zum Ausrichten auf den unteren Pegel der Synchronimpulse, eine Vergleichsschaltung mit einer Bezugsschwelle, die wenigstens diesem Pegel entspricht, und eine Schaltungsanordnung zum Messen der Dichte der diese Schwelle unterschreitenden Impulse aufweist.

3. Demodulator nach Anspruch 1, dadurch gekennzeichnet, dass die Schaltungsanordnung (400) zur automatischen Rauschregelung eine Schaltungsanordnung zum Ausrichten auf den unteren Pegel der Synchronimpulse, eine Schaltungsanordnung zum Unterdrücken dieser Impulse, eine Vergleichsanordnung mit zwei bestimmten Bezugsschwellen, die niedriger oder gleich diesem Pegel und höher als ein Weisspegel sind und eine Schaltungsanordnung zum Messen der Dichte der negativen, den niedrigen Pegel unterschreitenden und der positiven, den höheren Pegel Uberschreitenden Impulse aufweist.

4. Demodulator nach Anspruch 1, dadurch gekennzeichnet, dass die Schaltungsanordnung (400) zur automatischen Rauschregelung eine Schaltungsanordnung zum Ausrichten auf einen oberen Pegel, eine Vergleichsschaltung mit einer Bezugsschwelle, die wenigstens diesem Pegel entspricht und eine Schaltungsanordnung zum Messen der Dichte der die Bezugsschwelle überschreitenden positiven Impulse aufweist.

5. Demodulator nach einem der Ansprüche 2 bis 4, dadurch gekennzeichnete dass die Impulsdichte-Meßschaltung einen Zähler mit einem nachfolgenden Digital-Analog-Wandler aufweist.

**Claims**

1. A phase or frequency demodulator comprising an automatic gain control circuit (100) for producing from the non-controlled incoming carrier wave a modulated signal of a constant average level, and also a phase-locked loop (200) for producing a demodulated signal from said modulated signal and optionally a signal-shaping circuit (300) for shaping the output signal of the loop, a feedback path being additionally provided between the output of the loop or of the signal- shaping circuit and the automatic gain control circuit, said demodulator being characterized, in that said path comprises an automatic noise control circuit (400) for producing an analog signal proportional to the rate at which the loop is temporarily disabled.

2. A demodulator as claimed in Claim 1, characterized in that the automatic noise control circuit (400) comprises a circuit for clamping the synchronizing pulses on the lower level thereof, a comparator circuit having a reference threshold which is substantially equal to this level, and a circuit for measuring the rate of the negative pulses decreasing to below this threshold.

3. A demodulator as claimed in Claim 1, characterized in that the automatic noise control circuit (400) comprises a circuit for clamping the synchronizing pulses on the lower level thereof, a circuit for suppressing these pulses, a comparator circuit having two predetermined reference thresholds lower than or equal to this lower level and higher than a so-called white level, respectively, and a circuit for measuring the rate of the negative pulses which decrease to below the lower threshold and positive pulses which exceed the higher threshold.

4. A demodulator as claimed in Claim 1, characterized in that the automatic noise control circuit (400) comprises a clamping circuit for clamping on a higher level, commonly denoted as the white level, a comparator circuit having a reference threshold at least equal to this level, and a circuit for measuring the rate of the positive pulses exceeding the referent threshold.

5. A demodulator as claimed in any one of the Claims 2 to 4, characterized in that the pulse rate measuring circuit comprises a counter followed by a digital-to-analog converter.

FIG.1

FIG. 2